# FASCICULE DE BREVET EUROPEEN

(11) **EP 2 694 277 B1**
(45) Date de publication et mention de la délivrance du brevet: **15.06.2016**
(21) Numéro de dépôt: 12712654.8
(22) Date de dépôt: 02.04.2012
(51) Int. Cl.: B29C 70/46, H05K 5/00, B29C 33/06, H04M 1/02, H05B 6/02, B29C 35/08

(54) **DISPOSITIF ET PROCÉDÉ POUR LE COMPACTAGE-CONSOLIDATION D'UNE PIÈCE EN MATÉRIAU COMPOSITE À MATRICE THERMOPLASTIQUE RENFORCÉE PAR DES FIBRES CONTINUES NOTAMMENT D'ORIGINE NATURELLE**
VORRICHTUNG UND VERFAHREN ZUM VERDICHTEN/KONSOLIDIEREN EINES TEILS AUS EINEM VERBUNDSTOFF MIT EINER THERMOPLASTISCHEN, ENDLOSFASERVERSTÄRKTEN MATRIX, INSBESONDERE FASERN NATÜRLICHEN URSPRUNGS
DEVICE AND METHOD FOR COMPACTING/CONSOLIDATING A PART MADE OF A COMPOSITE MATERIAL HAVING A THERMOPLASTIC MATRIX REINFORCED BY CONTINUOUS FIBERS, IN PARTICULAR FIBERS OF NATURAL ORIGIN

(30) Priorité: 01.04.2011 FR 1152814; 18.10.2011 US 275928
(43) Date de publication de la demande: 12.02.2014
(73) Titulaire: Roctool, 73370 Le Bourget du Lac (FR)
(72) Inventeur: FEIGENBLUM, José, F-73170 Saint-Paul (FR); GUICHARD, Alexandre, F-73310 La Chapelle du Mont du Chat (FR)
(74) Mandataire: Ipside
(86) Numéro de dépôt international: PCT/EP2012/056006
(87) Numéro de publication internationale: WO 2012/131112

(56) Documents cités:
- DE-A1-102007 054 723
- FR-A1- 2 887 739
- US-A1- 2002 185 767
- Fibershell: "Procédé de fabrication - Fibershell", You Tube , 22 octobre 2010 (2010-10-22), XP002663256, Extrait de l'Internet: URL:http://www.youtube.com/watch?v=hQoZsjY WSj0&feature=player_embedded [extrait le 2011-11-09]

## Description

L'invention concerne un dispositif et un procédé pour le compactage-consolidation d'une pièce en matériau composite à matrice thermoplastique renforcé par des fibres continues notamment d'origine naturelle. L'invention est plus particulièrement adaptée à la production en grande série d'une pièce composite à matrice thermoplastique en, forme de demi-coque, non développable, comprenant 4 bords tombés, selon un contour fermé, reliés par des raccordements trièdres en coins de malle. Une telle pièce est notamment destinée à être utilisée comme carter ou demi-coque pour des terminaux de télécommunication tels que des téléphones portables, des assistants numériques personnels ou des tablettes PC. La dite demi-coque peut être utilisée alternativement, mais non limitativement, comme l'enveloppe des composants électroniques et comme support d'écran lors de l'assemblage de l'objet auquel elle est destinée ou peut-être utilisée comme coque de protection additionnelle apte à recevoir l'objet en question.

Dans ces deux exemples d'utilisation, ladite coque doit présenter des qualités structurales de rigidité et de résistance aux chocs, impacts et indentations auxquelles est susceptible d'être soumis ce type de matériels et aussi être réalisée avec précision de sorte à s'adapter parfaitement aux dimensions de l'objet et/ou des composants.

D'autres applications du procédé objet de l'invention peuvent être considérées notamment dans la réalisation d'une demi-coque destinée à la bagagerie afin de constituer des mallettes, valises ou étuis de protection.

Dans ces applications comme pour les précédentes, la réponse aux contraintes de résistance mécanique et de précision doit être obtenue tout en conservant des objets légers.

Ces biens de consommation sont produits en très grande série et sont soumis à des contraintes de saisonnalité et de décoration pour les adapter au goût des consommateurs ou aux couleurs et signes distinctifs de leurs distributeurs. Destinés au grand public et à des matériels renouvelés fréquemment, ces produits doivent être avantageusement recyclables ou, pour le moins, présenter un faible impact environnemental.

À cette fin, il est avantageux de réaliser une telle pièce, notamment une demi-coque pour tablette PC, dans un matériau composite stratifié comportant une matrice thermoplastique et un renfort fibreux continu, ledit renfort fibreux comprenant majoritairement des fibres naturelles d'origine végétale. Constituée d'une matrice en matière plastique et d'un renfort fibreux continu cette pièce est à la fois légère et particulièrement résistante. La nature thermoplastique de la matrice la rend facilement recyclable, de même que la nature des fibres de renfort en limite l'impact environnemental en termes d'obtention de la matière première et de son recyclage ou de son élimination en tant que déchet.

Cependant, le renfort étant constitué de fibres continues, une telle pièce ne peut être obtenue par des méthodes d'injection plastique généralement considérées pour ce type de fabrication en série. De même, un procédé d'estampage de flans thermoplastiques préconsolidés, tel que décrit dans le document FR-A-2922276, n'est pas applicable, car le préchauffage du flan avant son estampage, à une température suffisante pour permettre, par la fluidité de la résine, le glissement relatif des fibres dans les zones non développables, conduit à un risque de brûlure des fibres lorsque celles-ci sont naturelles, notamment d'origine végétale. Le procédé décrit dans le document FR-A-2922276 est ainsi plus particulièrement adapté à la fabrication d'une pièce dont le renfort fibreux est sous la forme de fibres de carbone, de verre ou d'aramide qui ne sont pas sujettes à ces phénomènes de brûlure à la température de fusion de la résine. Par ailleurs, les fibres naturelles contiennent de l'humidité à des taux qui peuvent être supérieurs à 10 %, laquelle humidité est susceptible de se transformer en vapeur d'eau lors de l'opération d'estampage à chaud et de produire des défauts de qualité.

Le procédé décrit dans le document FR-B-2882682, résout le problème de l'inflammabilité des fibres naturelles en réalisant le formage par un dispositif de sac à vide. Ce procédé ne permet pas d'obtenir des formes non développables serrées telles que des coins de malle au niveau des raccordements trièdres. En effet, ce procédé, qui ne permet pas de mettre les tissus en tension, conduit à la formation de plis et/ou d'essorages dans les zones non développables ou à proximité de celles-ci. Par ailleurs, ce procédé de formage/compactage par membrane ou vessie ne permet pas des cadences de production élevées, adaptées aux séries concernées par les applications visées.

Le document FR-A-2887739 divulgue un dispositif selon le préambule de la revendication 1 permettant de chauffer une forme au moyen d'inducteurs insérés dans des cavités de la forme.

Le document US 2002/0185767 A1 divulgue des inducteurs placés sur les flans d'une forme de moulage.

Ainsi, il n'existe pas, selon l'art antérieur, de procédé adapté à la réalisation d'une telle pièce.

Afin de résoudre les inconvénients de l'art antérieur, l'invention concerne un dispositif selon la revendication 1 pour le formage et la consolidation d'une préforme textile comportant des fibres continues imprégnées d'un polymère thermoplastique, lequel dispositif comprend :
i. une matrice comprenant une forme comportant une empreinte correspondant à la forme de la pièce, laquelle forme s'étend en profondeur entre un plan d'entrée et un fond et est insérée dans une carcasse ;
ii. des moyens de chauffage par induction de la forme comprenant deux inducteurs formant chacun au moins une spire dans des plans de hauteurs différentes, sensiblement parallèles au plan d'entrée de l'empreinte et compris entre ledit plan d'entrée et le fond de la forme ;
iii. des moyens de refroidissement de la matrice ;
iv. un poinçon comportant une partie en saillie correspondant à la forme de la pièce et distante de l'empreinte d'une valeur d'entrefer définie, et une partie apte à réaliser un serre flan entre ledit poinçon et la matrice.

Ainsi les inducteurs entourant la forme permettent de chauffer localement et rapidement celle-ci, jusqu'à une température suffisante pour assurer la fusion du polymère thermoplastique imprégnant la préforme, en assurant une température uniforme sur toute la surface de l'empreinte, sans chauffer ou en ne chauffant que modérément les bords de la matrice, qui coopèrent avec le bord du poinçon pour serrer les bords de la préforme et maintenir les fibres en tension lors du formage.

L'invention concerne également un procédé selon la revendication 11 pour la fabrication d'une pièce comprenant quatre bords tombés de contourfermé, constituée d'un matériau composite stratifié comportant une matrice thermoplastique et un renfort fibreux à fibres continues, notamment d'origine végétale, mis en oeuvre au moyen du dispositif objet de l'invention, le quel procédé comprend les étapes consistant à :
a. découper un flan non consolidé dans un tissu imprégné d'un polymère thermoplastique ;
b. placer ledit flan au-dessus de l'empreinte d'un dispositif selon l'invention;
c. estamper ledit flan en descendant le poinçon dans l'empreinte tout en maintenant les bords du flan sur le pourtour de l'empreinte et en maintenant le flan en pression dans l'entrefer entre le poinçon et l'empreinte ;
d. chauffer la partie du flan se trouvant dans l'empreinte à une vitesse de chauffage au moins égale à 2 °s⁻¹ jusqu'à une température égale ou supérieure à la température de fusion du polymère thermoplastique en maintenant la pression dans l'entrefer et sans atteindre la température de fusion dudit polymère sur les bords maintenus sur le pourtour de ladite empreinte ;
e. refroidir l'empreinte à une vitesse de refroidissement supérieure ou égale à 2°.s⁻¹ jusqu'à une température inférieure à la température de transition vitreuse du polymère en maintenant la pression dans l'entrefer ;
f. écarter le poinçon de l'empreinte et démouler la pièce.

Ainsi, le procédé objet de l'invention permet en combinant un chauffage et un refroidissement rapides et localisés de la partie du flan se trouvant dans l'empreinte, de réaliser la pièce en question sans risque de vaporisation de l'humidité contenue dans les fibres naturelles et en assurant une tension du tissu pour la réalisation des raccordements trièdres et des parties non développables de la pièce.

L'invention peut être mise en oeuvre selon les modes de réalisation avantageux exposés ci-après, lesquels peuvent être considérés individuellement ou selon toute combinaison techniquement opérante.

Avantageusement, les moyens de chauffage par induction du dispositif objet de l'invention comprennent un inducteur formant au moins une spire dans une cavité s'étendant entre le fond de l'empreinte et le fond de la forme. Ainsi, les inducteurs placés sous le fond de l'empreinte, chauffent la surface de celle-ci par conduction thermique entre la partie de la forme chauffée par induction par ces inducteurs et le fond de l'empreinte. La distance entre lesdits inducteurs et le fond de l'empreinte étant déterminée de sorte à obtenir l'uniformité de la température sur ledit fond en fonction de la conductivité thermique du matériau constituant la forme.

Avantageusement la carcasse est constituée d'un matériau non magnétique. Ainsi, le chauffage par induction est concentré dans la forme.

Selon un mode de réalisation préféré, la forme comprend un bloc dans lequel est taillée l'empreinte et une embase enserrant ledit bloc. Ce mode de réalisation facilite la réalisation de la forme, notamment la réalisation de cavités recevant les inducteurs avec des rayons de raccordement serrés, pour un cheminement des inducteurs au plus près de l'empreinte.

Avantageusement, selon ce dernier mode de réalisation, l'embase est constituée d'un matériau non magnétique. Ainsi le chauffage par induction est concentré sur le bloc comportant l'empreinte.

Avantageusement, les inducteurs sont constitués de câbles de cuivre tressés multibrins lesdits brins étant nus. Ainsi, lesdits inducteurs sont souples et sont aptes à suivre les contours de l'empreinte au plus près de celle-ci. L'absence d'isolant recouvrant chaque brin permet de passer dans lesdits câbles des intensités électriques élevées, pour un chauffage rapide de la forme, portant ainsi les inducteurs à des températures élevées sans risque de détérioration de ceux-ci.

Selon un mode de réalisation avantageux, la forme comprend deux alésages d'axes sécants formants une cavité apte à recevoir un inducteur, la continuité de la cavité entre les deux alésages étant réalisée par une pièce rapportée comprenant une cavité décrivant un rayon de raccordement adapté à la souplesse de l'inducteur. Ce mode de réalisation de la forme permet de réaliser des cavités comportant des rayons de raccordement locaux serrés, de sorte à ce que lesdites cavités suivent le contour de l'empreinte au plus près de celle-ci. Ainsi, le volume chauffé par induction est réduit ce qui permet d'atteindre des vitesses de chauffage élevées et un chauffage localisé de ladite forme.

Selon un mode de réalisation particulièrement avantageux du dispositif objet de l'invention, la forme est constituée d'un matériau métallique non magnétique, les cavités dans lesquelles s'étendent les inducteurs étant revêtues d'une couche de matériau ferromagnétique. Ce mode de réalisation favorise l'uniformisation de la température de l'empreinte par la conduction thermique du matériau la constituant.

Selon ce dernier mode de réalisation, le matériau constituant la forme est choisi parmi le cuivre et ses alliage ou parmi l'aluminium et ces alliage. Ces matériaux présentent à la fois une conductivité électrique et une conductivité thermique élevée de même qu'une effusivité thermique élevée. Ces caractéristiques permettent d'obtenir une homogénéisation de la température de l'empreinte rapide, du fait de la conductivité thermique élevée du matériau la constituant, même lorsque les inducteurs sont placés proches du contour de ladite empreinte. L'effusivité thermique du matériau constituant la forme permet un transfert rapide de la température de l'empreint à la préforme textile.

Le procédé et le dispositif objets de l'invention sont particulièrement adaptés à la réalisation d'une pièce, notamment une demi-coque pour tablette PC ou assistant numérique personnel, comprenant quatre bords tombés de contour fermé, constituée d'un matériau composite stratifié comportant une matrice constituée d'un polymère thermoplastique et des plis de renfort fibreux comprenant au moins 30 % de fibres continues constituées majoritairement des fibres naturelles d'origine végétale, laquelle comprend un pli de décoration intégré à la stratification et constitué d'un tissu imprimé, ladite couche de décoration étant intégralement recouverte par le polymère constituant la matrice. Ainsi le décor est imprimé à plat sur le tissu constituant le pli de décoration et la décoration de la pièce est résistante à l'usure.

Selon un mode de réalisation d'une pièce la matrice thermoplastique est constituée d'un premier PET bio-sourcé et les fibres de renfort comprennent des fibres constituées d'un deuxième PET bio-sourcé dont la température de fusion est supérieure à la température de fusion du premier PET. Ainsi, les fibres PET apportent un renfort supplémentaire, et permettent d'augmenter le taux de renfort de la pièce sans accroître les difficultés de mise en forme de celle-ci.

L'invention est exposée ci-après selon ses modes de réalisation préférés, nullement limitatifs, et en référence aux figures 1 à 10, dans lesquelles :
- la figure 1 représente de profil (figure 1A), de face (figure 1B) et en perspective de profil (figure 1 C), un exemple de réalisation d'une pièce ;
- la figure 2 est un exemple de réalisation de la matrice d'un outillage pour la mise en oeuvre du procédé de fabrication d'une pièce selon l'invention ;
- la figure 3, représente une partie de la matrice selon la même vue en perspective que celle de la figure 2, la forme ayant été démontée pour laisser apparaître la carcasse ;
- la figure 4 montre en vue de dessous de la forme l'outillage de la figure 2, sans la carcasse de maintien ;
- la figure 5 est une vue de dessous d'une partie de la forme, en l'occurrence de la pièce comprenant l'empreinte de l'outillage de la figure 2 ;
- la figure 6 représente un synoptique d'un exemple de réalisation du procédé ;
- la figure 7 illustre un exemple de cycle pression-température utilisé au cours du formage-consolidation d'une pièce selon le procédé objet de l'invention ;
- la figure 8 est une vue en section d'un inducteur utilisé pour le chauffage de l'outillage selon un exemple de réalisation de l'invention ;
- la figure 9 est une vue partielle en coupe d'un exemple de réalisation de l'outillage selon l'invention dans le cas où la forme présente un embouti profond, figure 9A selon une coupe A-A telle que définie figure 2, figure 9B, selon une coupe BB définissant un plan parallèle au fond de l'empreinte et figure 9C selon une coupe partielle dans un plan perpendiculaire au plan de coupe B-B dans une zone de raccordement en coin de malle de la forme ;
- et la figure 10, représente selon une vue partie en coupe D-D définie figure 4, un détail de réalisation des cavités recevant les inducteurs dans le bloc de la forme, selon un exemple de réalisation du dispositif objet de l'invention.

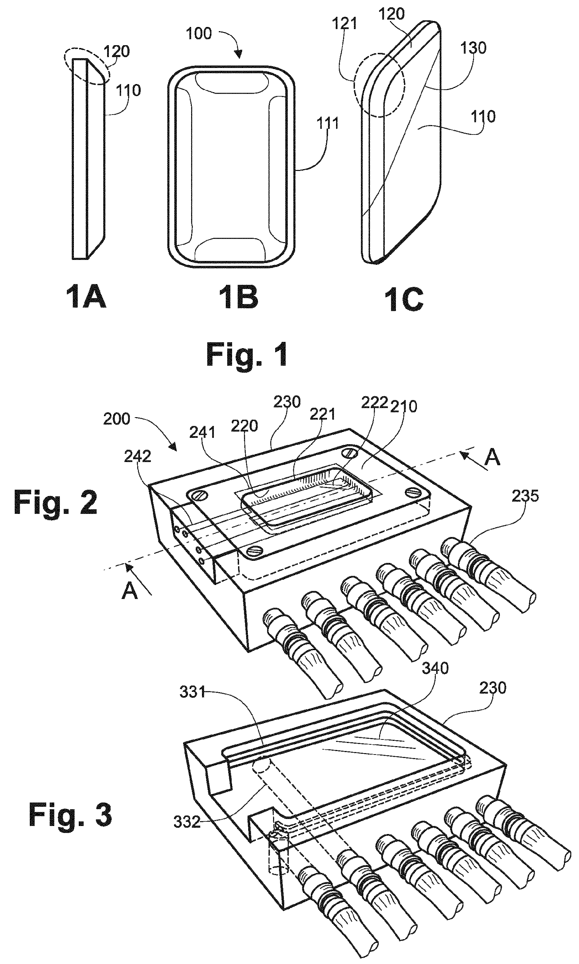

Figure 1, selon un exemple de réalisation, la pièce (100) se présente sous la forme d'une demi-coque comprenant un fond (110) et des bords tombés (120). Le contour (111) de la pièce (100) est continu de sorte que la pièce comporte des zones non développables (121), dites « coins de malle », aux raccordements trièdres entre les bords tombés (120) et le fond (110). Le fond est ici représenté plan. Selon un mode de réalisation avantageux (non représenté) le fond peut suivre une surface incurvée en double courbure. Ladite pièce (100) est constituée d'un composite stratifié comprenant plusieurs plis comportant des fibres dites continues (130). Les fibres, dites continues, s'étendent de manière ininterrompue d'un bord à l'autre de la pièce (100). Selon un mode de réalisation avantageux, lesdites fibres sont constituées de fibres continues monolithiques ou de fibres continues reconstituées, résultant d'un assemblage de plusieurs filaments par exemple sous la forme de fibres craquées filées.

Figure 2, selon un exemple de réalisation du dispositif objet de l'invention, adapté à la fabrication d'une telle pièce, celui-ci comprend une matrice (200) laquelle matrice est apte à être fixée sur le plateau d'une presse (non représentée). Ladite matrice (200) comprend un premier ensemble dit « forme » (210) lequel comporte l'empreinte (220) qui reproduit, en creux, la surface extérieure de la pièce (100) à réaliser. La forme (210) est placée dans une carcasse (230) laquelle carcasse réalise l'interface mécanique avec le plateau de la presse et supporte également plusieurs fonctions techniques. Ainsi, la carcasse (230) est apte à recevoir différentes formes (210) correspondant à différentes pièces. Le contour (221) de l'intersection entre l'empreinte (220) et le plan supérieur de la forme (210) défini le plan d'entrée de l'empreinte. La forme (210) comprend un dispositif de chauffage par induction. Ce dispositif comprend un premier inducteur (241) constitué par un circuit s'étendant dans un plan et formant une spire à une hauteur à proximité du plan d'entrée de l'empreinte (220). Selon cet exemple de réalisation, un deuxième inducteur (242) est constitué par un circuit s'étendant dans un plan et formant au moins une spire à une hauteur à proximité du fond (222) de l'empreinte (220). Les deux circuits (241, 242) sont reliés en série à un générateur.

Figure 3, la carcasse comprend un circuit de circulation fluide autour de la forme. Ce circuit est représenté partiellement et schématiquement sur la figure 3. Ledit circuit de circulation fluide, comprend des canalisations (331) aptes à refroidir les bords de la forme et le plan d'entrée de l'empreinte, ainsi que des canalisations (332) aptes à refroidir le fond (222) de la forme. Les dites canalisations (331, 332) qui forment un réseau sont alimentées en fluide par des moyens (235) d'adduction. Le fluide de refroidissement est de composition majoritairement aqueuse afin d'assurer un refroidissement efficace de la forme (210). La circulation du fluide dans ce réseau est réalisée sous basse pression et en circuit ouvert, avantageusement en insérant un réservoir tampon dans le circuit, de sorte que le fluide puisse éventuellement bouillir sans risque d'explosion. Selon un premier exemple de mise en oeuvre de ce réseau de fluide, la circulation dudit fluide est maintenue durant de chauffage de la forme par induction, ce moyen de chauffage étant suffisamment énergique pour permettre ce mode de fonctionnement. Alternativement et préférentiellement, la circulation du fluide est interrompue et le circuit purgé avant le chauffage de la forme, ladite circulation du fluide n'étant établie que lors des phases de refroidissement.

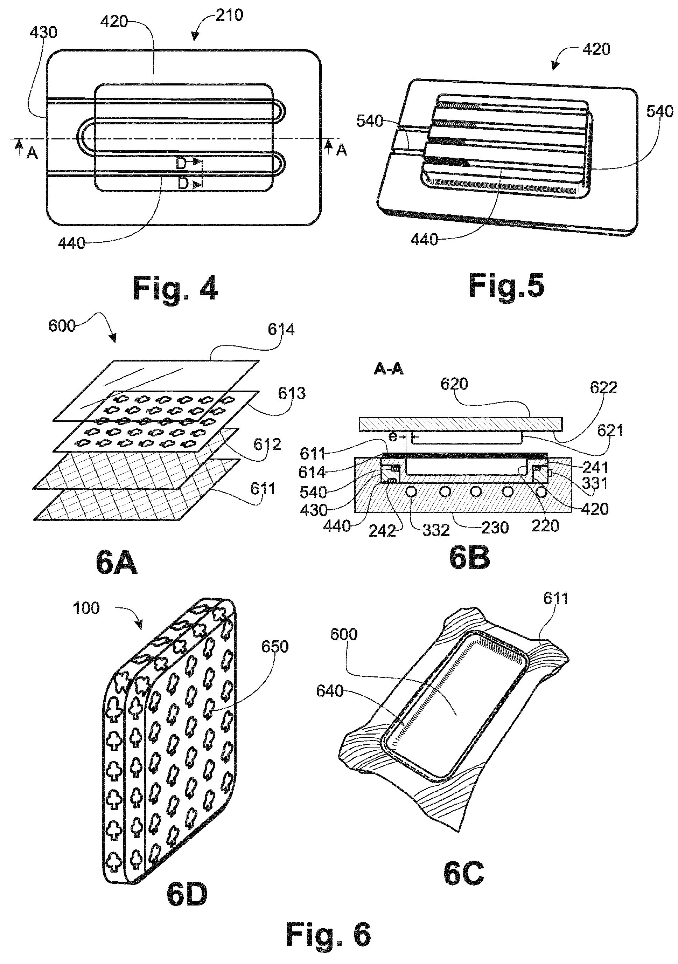

Figure 4, la forme (210) est constituée de deux pièces assemblées :
- une embase (430)
- et un bloc (420) comportant l'empreinte (220) qui est logé dans ladite embase.

Une rainure (440) s'étend en formant des spires entre l'embase (430) et le bloc (420) et sert de logement à un inducteur (242) placé à proximité du fond de l'empreinte. Cette rainure (440) est fermée par le fond (340) de la carcasse (230) lorsque la forme (210) est montée dans ladite carcasse, formant ainsi une cavité dans laquelle s'étend le deuxième inducteur (242). Afin d'éviter que la carcasse ne soit chauffée par induction et pour concentrer ce mode de chauffage dans la forme, ladite carcasse est constituée d'un matériau non magnétique.

Figure 5, le bloc (420) comprend une rainure (540), laquelle rainure est refermée par l'embase (430) lorsque ledit bloc (420) est monté dans celle-ci, ladite rainure formant une cavité à proximité du plan d'entrée de l'empreinte, cavité dans laquelle s'étend le premier inducteur (241).

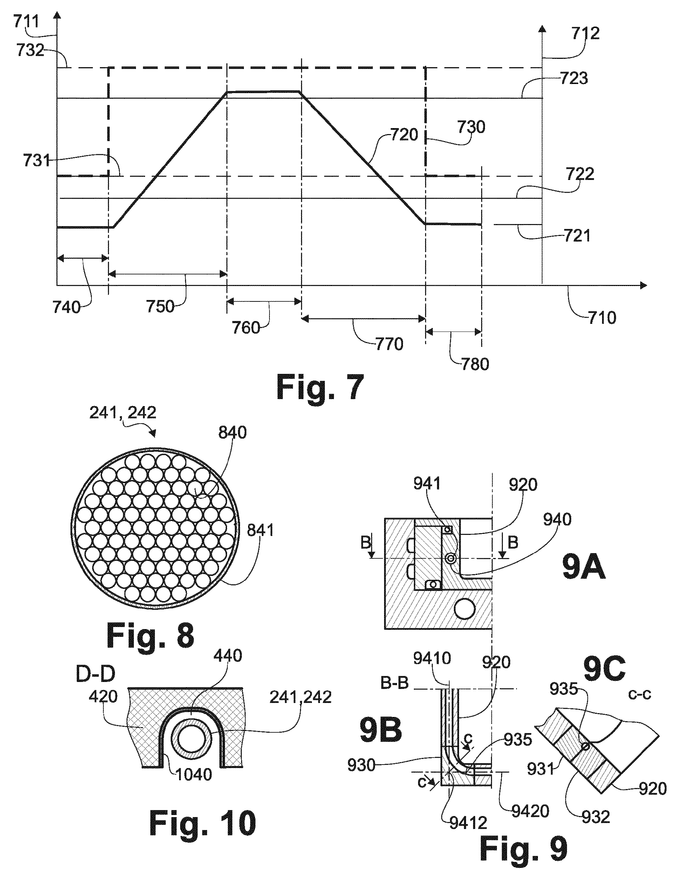

Figure 8, afin de pourvoir suivre le contour des cavités formées par les rainures de la forme, les inducteurs (241, 242) sont constitués de brins multiples (840) tressés, préférentiellement constitués de cuivre (Cu). La constitution multibrins permet, d'une part, de réduire la section des inducteurs, y compris pour un fonctionnement à haute fréquence, en répartissant les effets de peau sur tous les brins, et confère, par ailleurs, une plus grande souplesse auxdits inducteurs, permettant à ceux-ci de suivre le contour de l'empreinte au plus près de celle-ci, notamment dans les zones à faible rayon de courbure. Bien que l'utilisation de câbles multibrins pour la réalisation d'inducteurs soit connue de l'art antérieur, sous la forme de câbles dits de Litz, les câbles de l'art antérieur utilisent des brins isolés individuellement, ceci dans le but de confiner les effets de peau dans chaque brin et de profiter de toute la section de l'inducteur pour le passage de courant. L'effet de peau correspond à la concentration du courant électrique circulant dans un conducteur sur la périphérie de sa section, de sorte que la section effective de conduction du courant électrique est nettement plus faible que la section du conducteur qui est donc susceptible de subir un échauffement important par effet Joule du fait de la densité de courant conduit par cette section effective. L'effet est d'autant plus marqué que la fréquence du courant est élevée. Il est donc particulièrement sensible pour les inducteurs utilisant des fréquences élevées. Afin de contrer cet effet des câbles dits de Litz, tels que décrits ci-dessus sont utilisés. Toutefois, de tels câbles imposent une température de fonctionnement de l'inducteur limitée par la température que l'isolant individuel de chaque brin est apte à supporter, soit une température maximale de l'ordre de 180 °C pour les isolants à base de résine époxyde généralement utilisés à cette fin. Selon un effet surprenant, l'utilisation de brins, dits nus, non recouverts individuellement d'une gaine isolante, permet de passer des densités de courant toutes aussi importantes, mais sans limitation pratique de la température de l'inducteur, en réduisant le diamètre de celui-ci, du fait de l'absence de couche isolante sur chaque brin, et en améliorant encore la souplesse de l'inducteur. Une gaine (841) isolante, résistant à la chaleur, par exemple sous la forme d'une gaine tissée à partir de fibres de silice, est avantageusement utilisée pour isoler électriquement l'extérieur du câble multibrins.

Figure 9A, selon un exemple de réalisation du dispositif objet de l'invention, l'embouti de la forme est profond, un inducteur est placé dans en plan intermédiaire entre le fond de l'empreinte et le plan d'entrée, pour assurer le chauffage de l'empreinte (920). À cette fin, un inducteur (941) supplémentaire est placé dans un plan intermédiaire, par exemple, à mi-hauteur de l'empreinte. La cavité (940) apte à recevoir un tel inducteur (941) est alors de réalisation délicate par rainurage, particulièrement si l'inducteur doit être placé proche de la surface de l'empreinte (920). Dans ces conditions la cavité (940) est avantageusement réalisée par perçage, notamment par des techniques de perçage profond utilisant des forets dits % ou « *gundrill* ». Figure 9B, la difficulté de cette technique réside dans le suivi du contour de l'empreinte (920) par ladite cavité (940), suivi qui nécessite la réalisation de perçages d'axes (9410, 9420) sécants, dont au moins une extrémité doit ensuite être bouchée. Le point d'intersection (9412) des perçages se trouve alors éloigné des bords de l'empreinte (920) dans cette zone, ou l'efficacité du chauffage est primordiale et cette intersection constitue également un point anguleux qui demande à ce que l'inducteur soit plié selon un rayon de courbure faible. Pour résoudre cet inconvénient, un insert (930) est placé dans un logement pratiqué dans le bloc (920) comprenant l'empreinte, lequel insert (930) comprend une cavité (935) s'étendant selon un axe circulaire respectant le rayon de courbure minimal admissible par le câble constituant l'inducteur. Figure 9C, avantageusement, l'insert (930) est constitué de deux pièces (931, 932) assemblées, comprenant chacune une demi-rainure (935) réalisée en fraisage. Ainsi, la répartition spatiale des sources de chauffage énergique et la circulation fluide autour de la forme permettent de réaliser des cycles de chauffage-refroidissement très rapides de l'empreinte en assurant à la fois une distribution uniforme de la température sur toute la surface de l'empreinte (220) et de forts gradients de température sur les bords (221) de l'empreinte. Ainsi, la température de fusion de la résine est atteinte de manière uniforme dans l'empreinte, assurant ainsi une répartition uniforme du polymère thermoplastique constituant la matrice dans tout le volume de la pièce. Cependant cette température de fusion n'est pas atteinte au-delà des bords (221) de ladite empreinte, permettant ainsi le contrôle de la mise en tension et du glissement du tissu sur les bords afin d'éviter la formation de plis dans les zones non développables (121) de la pièce.

Figure 6, les caractéristiques avantageuses du dispositif objet de l'invention sont mises à profit pour réaliser une pièce selon un procédé

Selon un exemple de réalisation de ce procédé, figure 6A, plusieurs couches constituant les plis du composite final sont empilées afin de constituer une préforme textile (600). Les deux premières couches (611, 612) sont, par exemple, constitués d'un tissu de fibres végétales naturelles, telles que des fibres de lin, de coton ou de chanvre, poudrées d'un polymère thermoplastique, d'un tissu de telles fibres filmé avec un tel polymère ou d'un tissu comprenant des fibres thermoplastiques et végétales mêlées. À titre d'exemple non limitatif, le polymère thermoplastique est choisi dans un groupe comprenant :
- l'acrylonitrile butadiène styrène, ou ABS ;
- les polyoléfines ;
- le polytéréphtalate de butylène, ou PBT ;
- le polyéthylénimine, ou PEI ;
- le polyéthercétone, ou PEK ;
- le polyétheréthercétone, ou PEEK ;
- le poly (sulfure de phénylène), ou PPS ;
- des polyamides tels que le polycaprolactame (PA6) ou le polyhexaméthylène adipamide (PA6-6) ;
selon les propriétés recherchées pour la pièce.

Selon un autre exemple de réalisation, non limitatif, un polymère thermoplastique bio-sourcé est utilisé, lequel est avantageusement choisi dans un groupe comprenant :
- les polyamides (PA), notamment le PA11
- le polyéthylène (PET) bio-sourcé ;
- l'acide polylactique (PLA) ;
- ou encore des polyesters bio-sourcés.

Les polymères thermoplastiques selon ces différents exemples de réalisation, présentent des températures de fusion supérieures à 100 °C voir même à 200 °C ou 300 °C pour certains d'entre eux. Or, des fibres naturelles comme les fibres de lin sont susceptibles de se dégrader par brûlure au-delà de 120 °C et l'humidité qu'elles contiennent est susceptible de se vaporiser au-delà de 100 °C. Ces difficultés de mise en oeuvre sont résolues par la dynamique du procédé, dynamique rendue possible par le dispositif objet de l'invention notamment pour le chauffage-refroidissement de l'ensemble constituant la matrice.

En revenant à la figure 6A, une troisième couche (613) est constituée d'un tissu imprimé, lequel tissu n'a qu'un rôle décoratif. À titre d'exemple, il peut s'agir d'un tissu de coton imprimé. La quatrième couche (614) est un film thermoplastique, choisi avantageusement parmi les polymères cités ci-avant.

Selon un autre exemple de réalisation, le procédé objet de l'invention est utilisé pour réaliser des pièces à partir de flans sous la forme de tissus comprenant des fibres mêlées de polyéthylène (PET) de constitutions différentes. Les différences de constitution desdites fibres leur confèrent des températures de fusion différentes. Ces fibres peuvent être issues en partie ou en totalité de polyéthylène bio-sourcé. Ainsi, le contrôle précis de la température dans l'empreinte (220) permet de réaliser la fusion d'une partie des fibres seulement, lesquelles constitueront la matrice de la pièce finale, les autres fibres conservant leur intégrité et leur rôle de renfort de la pièce. Cette mise en oeuvre est compatible avec l'insertion d'un tissu de décoration dans l'empilement. Cette version de mise en oeuvre du procédé est particulièrement adaptée à la réalisation de pièces destinées à la bagagerie.

Même si elles ne sont pas portées à leur température de fusion lors du formage, les fibres de renfort PET sont déformables à la température de fusion du polymère constituant la matrice du composite. Ainsi, le taux de renfort peu être augmenté par la présence de ces fibres PET sans accroître les difficultés de mise en forme de la pièce.

Figure 6B, l'empilage (611, 612, 613, 614) est placé sur la matrice (200) du dispositif objet de l'invention, sans préparation spécifique pour les pièces de petite dimension telles que les coques de protection pour téléphone portable. Dans le cas de la réalisation d'une demi-coque de plus grande dimension, destinée, par exemple, à constituer un couvercle ou un fond de valise ou de malle, l'empilage de tissus peut être stabilisé en assemblant les couches entre elles par des points ou des lignes de soudure, notamment pour assurer l'orientation du motif du tissu imprimé par rapport à la pièce finale. La matrice (200) est placée sur l'un des plateaux d'une presse (non représenté). Le tissu imprimé (613) est, selon cet exemple de réalisation, placé face imprimée tournée vers le fond de l'empreinte (220) et vers l'extérieur de l'empilement, de sorte que cette face imprimée soit visible sur la face convexe de la pièce. L'empilement de tissus étant placé sur la matrice (200) le cycle de formage-consolidation est engagé.

La figure 7 représente dans un diagramme temps (710), température (712) et force (711), l'évolution de la température (720) dans l'empreinte, et de la force de fermeture (730) du dispositif objet de l'invention au cours d'un tel cycle de formage-consolidation. La première étape (740) correspond au placement des tissus sur la matrice (200) du dispositif objet de l'invention, celle-ci étant à température ambiante (721), la force de fermeture dudit dispositif étant nulle (731).

Au cours de la deuxième étape (750), l'empilement de tissus est estampé entre un poinçon (620) et la matrice (200) par la fermeture du dispositif objet de l'invention à la force de fermeture de la presse (732).

Figure 6B, Le poinçon (620) est fixé sur le plateau d'une presse (non représenté), opposé au plateau sur lequel est fixée la matrice (200). Le poinçon (620) comporte deux parties. Une première partie (621) est de forme complémentaire à celle de l'empreinte (220), distante de celle-ci d'un entrefer (e) lorsque le piston (620) est descendu au contact de la matrice. Une seconde partie (622), s'étend dans un plan supérieur à la première partie (621) et constitue un serre-flan apte à pincer les bords de l'empilage de tissus (611, 612, 613, 614) entre ledit serre-flan et la partie supérieure de la matrice correspondant au plan d'entrée de l'empreinte (220). Avantageusement la première partie (621) du poinçon (620) faisant saillie par rapport au serre-flan (622) est constituée de silicone. Le rapprochement du poinçon (620) et de la matrice (200) par la fermeture de la presse, pousse la partie centrale de l'empilement de tissu dans l'empreinte (220) et pince les bords de l'empilement de tissu entre les bords de l'empreinte et le serre-flan. Ainsi les tissus sont tendus, particulièrement dans les zones non développables évitant ainsi la formation de plis dans ces zones.

En revenant à la figure 7, au cours de l'étape d'estampage (750), après la fermeture de la presse, la température de l'empreinte est augmentée très rapidement à une vitesse de chauffage au moins égale à 2 °C. s⁻¹ par la mise en oeuvre du chauffage par induction, jusqu'à une température égale ou supérieure à la température de fusion (723) du matériau thermoplastique constituant la matrice de la pièce, la pression de fermeture de l'outillage étant maintenue constante. A titre d'exemple, dans le cas de l'utilisation d'une matrice thermoplastique de type PA11, dont la température de fusion est de 185 °C cette température peut être atteinte en 60 secondes.

La phase d'estampage (750) est suivie d'une phase de maintien (760), l'empreinte étant maintenue à la température de fusion (723) de la résine et la force de fermeture du moule étant également maintenue à sa valeur maximale (732). Préférentiellement cette phase de maintien (760) est d'une durée de l'ordre de 30 secondes.

À l'issue de cette phase de maintien (760), le chauffage par induction est interrompu et la circulation de fluide dans les conduits (331, 332) de la carcasse (230) est rétablie de sorte à refroidir rapidement la forme (210). La force de fermeture du moule est maintenue durant cette phase de refroidissement (770) qui permet la consolidation de la pièce. Cette consolidation est atteinte lorsque la température de l'empreinte est inférieure à la température (722) de transition vitreuse de la résine thermoplastique. Le refroidissement est poursuivi jusqu'à température ambiante (721), avant de procéder à l'ouverture de l'outillage et à l'étape de démoulage (780) de la pièce. À cette fin, dans le cadre d'une fabrication en grande série, la matrice (200) de l'outillage est pourvue de moyens (non représentés) pour automatiser ce démoulage.

La pièce est alors transférée vers un poste de détourage. En effet, figure 6C, à l'issue de l'opération de formage-consolidation, l'ébauche démoulée présente une partie consolidée (600) et en bordure, des parties de tissu non consolidées. L'opération de détourage vise à éliminer ces bords non consolidés.

Ledit détourage peut être réalisé par un outil de découpe monté sur une presse attenante à la presse utilisée pour les opérations de formage-consolidation, ou par un usinage, par exemple en fraisage sur une machine à commande numérique. Selon ces exemples, le détourage est réalisé selon un contour (640) situé dans la partie consolidée (600) de l'ébauche. Les bords tombés de la partie consolidée (600) de l'ébauche sont ainsi plus larges que ceux de la pièce finale afin de réaliser le détourage dans une partie consolidée.

Figure 6D, la pièce (100) est finie à l'issue de ce détourage. La face décorée (650) se situe dans cet exemple de réalisation à l'extérieur de la pièce sur sa partie convexe. La décoration est intégrée dans l'épaisseur de la pièce sous une couche de résine. Elle est par conséquent beaucoup plus résistante qu'une décoration par impression sur la surface de la pièce finie

En revenant à la figure 6B, les inducteurs (241, 242) étant placés très proches de l'empreinte, la combinaison de ces caractéristiques avec la dynamique élevée de chauffage-refroidissement permet de ne déclencher la fusion de la matrice thermoplastique que dans la partie de l'empilement de tissus se situant dans l'empreinte, les bords de l'empilement restant en dessous de la température de fusion de la matrice.

Au total, le séjour de l'ensemble des tissus situés dans l'empreinte (220) à une température supérieure à 100 °C est inférieur à 2 minutes. Ce court séjour à haute température, combiné à une température uniforme sur toute la surface de l'empreinte permet à la fois d'assurer l'absence de brûlure ou de décoloration des fibres des tissus de renfort (611, 612) ainsi que du tissu de décoration (613), l'absence de défauts liés à la vaporisation de l'humidité contenue dans les fibres tant des tissus de renfort (611, 612) que du tissu imprimé (613) et une répartition uniforme de la résine dans tout le volume de la pièce. L'uniformité de la température sur la surface de l'empreinte durant tout le cycle permet également d'obtenir un aspect uniforme de la surface de la pièce notamment en termes d'état de surface. Le mode de réalisation représenté figure 9, facilite la réalisation de telles cavités revêtues dans les zones à faible rayon de raccordement.

Figure 10 selon un exemple de réalisation du dispositif objet de l'invention, le bloc (420) constituant la forme est constitué d'un matériau électriquement conducteur et non magnétique. À titre d'exemple non limitatif, ledit bloc (420) est constitué de cuivre (Cu) ou d'un alliage de cuivre et de béryllium (Be). Selon un autre exemple de réalisation, ledit bloc est constitué d'un alliage d'aluminium. Ces matériaux présentent une conductivité thermique et une conductivité magnétique élevées. Selon ce mode de réalisation, la surface des rainures (440) réalisant les cavités recevant les inducteurs (241, 242) sont couvertes par un revêtement (1040) constitué d'un matériau ferromagnétique, par exemple du nickel ou un alliage ferreux. Ainsi, lorsqu'un courant électrique alternatif à haute fréquence circule dans lesdits inducteurs (241, 242), ledit revêtement (1040) est chauffé par induction et transmet sa chaleur au bloc (420), qui la transmet par conduction à la pièce placée dans l'empreinte. La forte conductivité thermique du matériau constituant le bloc (420) selon ce mode de réalisation, permet une homogénéisation rapide de la température sur toute la surface de l'empreinte.

La description ci-avant et les exemple de réalisation montrent que l'invention atteint les objectifs visés, en particulier le dispositif objet de l'invention permet par un chauffage rapide et uniforme de l'empreinte de réaliser des pièces composites comprenant des fibres d'origine végétale dans une matrice thermoplastique.

## Revendications

1. Dispositif pour le formage et la consolidation d'une préforme (600) textile comportant des fibres continues imprégnées d'un polymère thermoplastique, comprenant:
i. une matrice (200) comprenant une forme (210) comportant une empreinte (220) correspondant à la forme de la pièce, laquelle forme s'étend en profondeur entre un plan d'entrée et un fond et est insérée dans une carcasse (230) ;
ii. des moyens (241, 242) de chauffage par induction de la forme (210);
iii. des moyens (235, 331, 332) de refroidissement de la matrice ;
iv. un poinçon (620) comportant une partie (621) en saillie correspondant à la forme de la pièce et distante de l'empreinte (220) d'une valeur d'entrefer (e) définie, et une partie (622) apte à réaliser un serre flan entre ledit poinçon et la matrice (200) ;
**caractérisé en ce que**:
les moyens de chauffage par induction de la forme comprennent deux inducteurs s'étendant dans des cavités (440) de la forme (210) et formant chacun une spire dans des plans de hauteurs différentes, sensiblement parallèles au plan d'entrée de l'empreinte (220) et compris entre ledit plan d'entrée et le fond de la forme

2. Dispositif selon la revendication 1, **caractérisé en ce que** les moyens de chauffage par induction comprennent un inducteur (242) formant au moins une spire dans une cavité s'étendant entre le fond de l'empreinte et le fond de la forme.

3. Dispositif selon la revendication 1, **caractérisé en ce que** la carcasse (230) est constituée d'un matériau non magnétique.

4. Dispositif selon la revendication 1, **caractérisée en ce que** la forme (210) comprend un bloc (420) dans lequel est taillée l'empreinte et une embase (430) enserrant ledit bloc.

5. Dispositif selon la revendication 1, **caractérisé en ce que** l'embase (430) est constituée d'un matériau non magnétique.

6. Dispositif selon la revendication 1, **caractérisé en ce que** les inducteurs (241, 242, 941) sont constitués de câbles de cuivre tressés multibrins (840) lesdits brins étant nus.

7. Dispositif selon la revendication 1, **caractérisé en ce que** la forme (920) comprend deux alésages d'axes (9410, 9420) sécants formants une cavité (940) apte à recevoir un inducteur, la continuité de la cavité entre les deux alésages étant réalisée par une pièce (930) rapportée comprenant une cavité (935) décrivant un rayon de raccordement adapté à la souplesse de l'inducteur (941).

8. Dispositif selon la revendication 1, **caractérisé en ce que** le bloc (420) de la forme (210) est constitué d'un matériau métallique non magnétique, les cavités (440) dans lesquelles s'étendent les inducteurs (241, 242) étant revêtues d'une couche (1040) d'un matériau ferromagnétique.

9. Dispositif selon la revendication 6, **caractérisé en ce que** le bloc (420) de la forme (210) est constitué d'un matériaux choisi parmi le cuivre et ses alliages.

10. Dispositif selon la revendication 6, **caractérisé en ce que** le bloc (420) de la forme (210) est constitué d'un matériau choisi parmi l'aluminium et ses alliages.

11. Procédé pour la fabrication d'une pièce (100) comprenant quatre bords tombés de contour fermé, constituée d'un matériau composite stratifié comportant une matrice thermoplastique et un renfort fibreux à fibres continues, notamment d'origine végétale, mis en oeuvre au moyen d'un dispositif selon la revendication 1, comprenant les étapes consistant à :
a. découper un flan (600) non consolidé dans un tissu imprégné d'un polymère thermoplastique ;
b. placer (740) ledit flan au-dessus de l'empreinte (220) d'un dispositif selon la revendication 1 ;
c. estamper (750) ledit flan en descendant le poinçon (620) dans l'empreinte (220) tout en maintenant les bords du flan (600) sur le pourtour de l'empreinte et en maintenant le flan en pression dans l'entrefer (e) entre le poinçon (620) et l'empreinte (220) ;
d. chauffer la partie du flan se trouvant dans l'empreinte (220) à une vitesse de chauffage au moins égale à 2 °s⁻¹ jusqu'à une température égale ou supérieure à la température (723) de fusion du polymère thermoplastique en maintenant la pression dans l'entrefer et sans atteindre la température de fusion dudit polymère sur les bords maintenus sur le pourtour de ladite empreinte ;
e. refroidir (770) l'empreinte à une vitesse de refroidissement supérieure ou égale à 2°.s⁻¹ jusqu'à une température inférieure à la température de transition vitreuse du polymère en maintenant la pression dans l'entrefer ;
f. écarter le poinçon de l'empreinte et démouler la pièce.

## Patentansprüche

1. Eine Vorrichtung zum Gießen und Verstärken einer Textilien-Vorform (600) mit Endlosfasern, imprägniert mit thermoplastischem Polymer, bestehend aus:
i. einer Pressform (200) die einen Guss (210) mit einem Aufdruck (220) entsprechend der Form des Teils beinhaltet, dessen Guss sich zwischen einer Einlaufebene und einer Unterseite in die Tiefe erweitert und in einem Mantel (230) eingefügt ist;
ii. mittels Erhitzung (241, 242) des Gusses (210) durch Induktion;
iii. mittels Kühlung (235, 331, 332) der Pressform;
iv. eine Stanze (620) mit einem überstehenden Anteil (621) entsprechend der Form des Teils und abseits des Aufdrucks (220) mit einem festgelegten Abstandswert und einem Stück/Teil (622) das als Niederhalter zwischen besagter Stanze und Pressform dient (200);
**gekennzeichnet dadurch, dass**
die Induktionserwärmungs-Mittel aus zwei Induktoren bestehen, die sich in die Hohlstellen (440) des Gusses (210) erweitern und jede eine Windung in Ebenen von unterschiedlicher Höhe formen, wesentlich parallel zur Einlaufebene des Aufdrucks (220) und zwischen besagter Einlaufebene und der Unterseite des Gusses befindlich.

2. Die Vorrichtung entsprechend Anspruch 1, **gekennzeichnet dadurch, dass** die Induktionserwärmungs-Mittel eine Kavität enthalten, die sich zwischen der Unterseite des Aufdrucks und der Unterseite des Gusses ausdehnt.

3. Die Vorrichtung entsprechend Anspruch 1, **gekennzeichnet dadurch, dass** der Mantel (230) ein unmagnetisches Material enthält.

4. Die Vorrichtung entsprechend Anspruch 1, **gekennzeichnet dadurch, dass** der Guss (210) einen Block (420) beinhaltet, in dem der Aufdruck geschnitten wird und eine Basis (430), die besagten Block einschließt.

5. Die Vorrichtung entsprechend Anspruch 1, **gekennzeichnet dadurch, dass** die Basis (430) ein unmagnetisches Material enthält.

6. Die Vorrichtung entsprechend Anspruch 1, **gekennzeichnet dadurch, dass** die Induktoren (241, 242, 941) aus geflochtenen Multifilament-Kupferdrähten (840) bestehen, besagte Fäden sind blank.

7. Die Vorrichtung entsprechend Anspruch 1, **gekennzeichnet dadurch, dass** der Guss (920) aus zwei sich durchschneidenden Bohrlöchern (9410, 9420) besteht, die eine Kavität (940) formen, angepasst um einen Induktor aufzunehmen. Die Kontinuität der Kavität zwischen den zwei Bohrlöchern wird durch ein zusätzliches Stück/Teil (930) besorgt, das eine Kavität (935) enthält, die einen Verbindungsradius beschreibt, der der Flexibilität des Induktors (941) angepasst ist.

8. Die Vorrichtung entsprechend Anspruch 1, **gekennzeichnet dadurch, dass** der Block (420) des Gusses (210) ein unmagnetisches metallisches Material enthält, die Hohlstellen (440) in denen sich die Induktoren (241, 242) ausdehnen sind mit einer Schicht (1040) ferromagnetischen Materials umkleidet.

9. Die Vorrichtung entsprechend Anspruch 6, **gekennzeichnet dadurch, dass** der Block (420) des Gusses (210) ein Material enthält, das aus Kupfer und seinen Legierungen ausgewählt wurde.

10. Die Vorrichtung entsprechend Anspruch 6, **gekennzeichnet dadurch, dass** der Block (420) des Gusses (210) ein Material enthält, das aus Kupfer und seinen Legierungen ausgewählt wurde.

11. Eine Methode zur Herstellung einer Komponente (100) die vier Flanschränder mit geschlossener Kontur enthält, bestehend aus einem Schichtverbundwerkstoff mit einer thermoplastischen Matrix und Faserverstärkung mit Endlosfasern, insbesondere pflanzlichen Ursprungs, implementiert mit einer Vorrichtung in Übereinstimmung mit Anspruch 1, die folgende Schritte umfasst:
a. Schneiden eines nicht konsolidierten Vordrucks (600) in ein Gewebe, das mit thermoplastischem Polymer imprägniert ist;
b. Platzieren (740) besagten Vordrucks über die Form des Aufdrucks (220) einer Vorrichtung in Übereinstimmung mit Anspruch 1;
c. Prägung (750) besagten Vordrucks durch Bewegen der Stanze (620) in den Aufdruck hinein (220), dabei bleiben die Kanten des Vordrucks (600) auf der Peripherie des Aufdrucks erhalten und halten den Vordruck durch den Luftspalt zwischen der Stanze (620) und dem Aufdruck (220) unter Druck;
d. Erwärmung des Teils des Vordrucks der sich im Aufdruck (220) befindet, mit einer Heizrate von mindestens 2°s-1, auf eine Temperatur die gleich oder höher als die Schmelztemperatur (723) des thermoplastischen Polymer ist, wobei der Druck in der Luftspalte erhalten bleibt und ohne dass die Schmelztemperatur an den Rändern besagten Polymers erreicht wird, der auf der Peripherie besagten Aufdrucks platziert ist;
e. Kühlung (770) des Aufdrucks mit einer Abkühlgeschwindigkeit die höher oder gleich 2°.s-1 der Temperatur unterhalb der Glasübergangstemperatur des Polymers liegt, wobei der Druck in der Luftspalte erhalten bleibt;
f. Entfernen der Stanze vom Aufdruck und das Teil aus der Form stürzen.

## Claims

1. A device for casting and consolidating a textile preform (600) with continuous fibers impregnated with a thermoplastic polymer, comprising:
i. a matrix (200) comprising a cast (210) with an imprint (220) corresponding to the shape of the part, which cast extends in depth between an entry plane and a bottom and is inserted in a carcass (230);
ii. means of heating (241, 242) the cast (210) by induction;
iii. means of cooling (235, 331, 332) the matrix;
iv. a punch (620) with a projecting portion (621) corresponding to the shape of the part and remote from the imprint (220) with a defined gap value, and a piece (622) capable of serving as a blank-holder between said punch and matrix (200);
**characterized by** the fact that
the induction heating means comprise two inductors extending in cavities (440) of the cast (210) and each forming a coil in planes of different heights, substantially parallel to the entry plane of the imprint (220) and located between said entry plane and the bottom of the cast.

2. The device according to claim 1, **characterized by** the fact that the induction heating means are comprise a cavity extending between the bottom of the imprint and the bottom of the cast.

3. The device according to claim 1, **characterized by** the fact that the carcass (230) comprises a nonmagnetic material.

4. The device according to claim 1, **characterized by** the fact that the cast (210) is including a block (420) in which the imprint is cut, and a base (430) enclosing said block.

5. The device according to claim 1, **characterized by** the fact that the base (430) is including a nonmagnetic material.

6. The device according to claim 1, **characterized by** the fact that the inductors (241, 242, 941) are constituted of braided multifilament copper wires (840) said filaments being bare.

7. The device according to claim 1, **characterized by** the fact that the cast (920) comprises two intersecting bores (9410, 9420) forming a cavity (940) adapted to receive an inductor, the continuity of the cavity between the two bores being provided by an added piece (930) including a cavity (935) describing a connecting radius adapted to the flexibility of the inductor (941).

8. The device according to claim 1, **characterized by** the fact that the block (420) of the cast (210) includes a nonmagnetic metallic material, the cavities (440) in which the inductors (241, 242) extend being coated with a layer (1040) of a ferromagnetic material.

9. The device according to claim 6, **characterized by** the fact that the block (420) of the cast (210) includes a material selected from copper and its alloys.

10. The device according to claim 6, **characterized by** the fact that the block (420) of the cast (210) includes a material selected from aluminum and its alloys.

11. A method for manufacturing a component (100) that includes four flanges edges with closed contour, consisting of a laminated composite material with a thermoplastic matrix and fibrous reinforcement with continuous fibers, notably of plant origin, implemented with a device in accordance with claim 1, comprising the steps to:
a. cutting an unconsolidated blank (600) in a fabric impregnated with a thermoplastic polymer;
b. placing (740) the said blank over the mold imprint (220) of a device according to claim 1;
c. stamping (750) the said blank by moving the punch (620) down into the imprint (220) while maintaining the edges of the blank (600) on the periphery of the imprint and keeping the blank under pressure within the air gap between the punch (620) and the imprint (220);
d. heating the portion of the blank located in the imprint (220) at a heating rate of at least 2°s-1 up to a temperature equal to or higher than the melting temperature (723) of the thermoplastic polymer, while maintaining the pressure in the airgap and without reaching the melting temperature of the said polymer on the edges placed on the periphery of said imprint;
e. cooling (770) the imprint at a cooling rate higher than or equal to 2°.s-1 to a temperature below the glass transition temperature of the polymer while maintaining the pressure in the airgap;
f. removing the punch of the imprint and unmold the part.
